# EUROPEAN PATENT APPLICATION

(11) **EP 1 819 045 A1**
(43) Date of publication of application: **15.08.2007**
(21) Application number: 04799861.2
(22) Date of filing: 22.11.2004
(51) Int. Cl.: H03K 17/00, H03K 17/62, H03K 17/693, H01H 47/00

(54) **MULTIPLEXER CIRCUIT**

(71) Applicant: Test Research Laboratories Inc., Nagasaki-shi Nagasaki 851-0122 (JP)
(72) Inventor: TANAKA, Yoshito, c/o Test Research Lab. Inc., Nagasaki-shi, Nagasaki 851-0122 (JP)
(74) Representative: Vossius & Partner
(86) International application number: PCT/JP2004/017659
(87) International publication number: WO 2006/054365

(57) **Abstract**

Relay switches are provided between the output terminals of multiplexers in a certain layer in a tree structure and an input terminal of a multiplexer in a layer that is one level higher than the certain layer; the relay switch connected to the multiplexer, among the multiplexers in the certain layer, that is involved in selecting a signal is turned ON and the relay switches connected to the other multiplexers are turned OFF, whereby the resistance components and the capacitance components of the multiplexers whose corresponding relay switches have been turned OFF can be disconnected from the tree structure, thereby reducing the value of the time constant CR that affects the operating speed of the multiplexer. As a result, the disadvantage that the increase in the time constant decelerates the operating speed of the entire multiplexer circuit can be suppressed.

## Description

### [Technical Field]

The present invention relates to a multiplexer circuit that switches a plurality of signals that are inputted thereto in parallel with one another, thereby selecting the signals one by one, and outputs the signals in series.

### [Background Art]

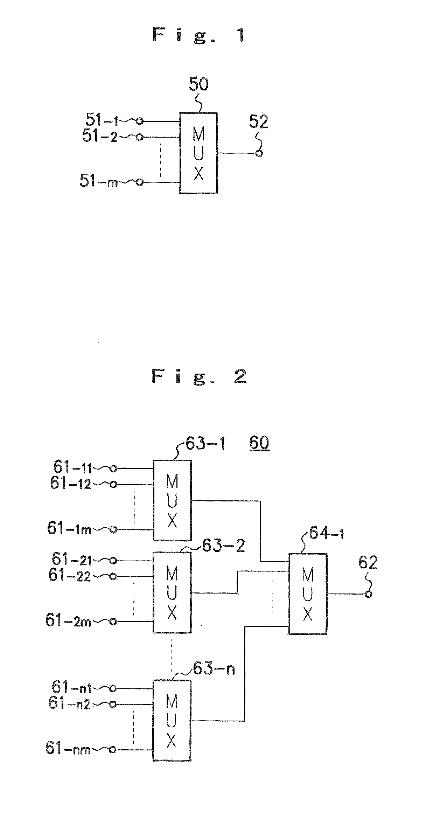

As illustrated in Figure 1, a conventional and commonly used multiplexer circuit 50 is configured in such a way that input signals that are supplied in parallel to a plurality of input terminals 51₋₁, 51₋₂, ..., 51₋ₘ are sequentially switched and outputted one by one from an output terminal 52, as a serial signal.

In addition, in the case where the number of signals that are inputted in parallel with one another is considerably large, a plurality of multiplexers 63₋₁, 63₋₂, ..., 63₋ₙ, 64₋₁ may be connected in a tree fashion, as illustrated in Figure 2, so as to configure a multiplexer circuit.

In a multiplexer circuit 60 illustrated in Figure 2, front-stage multiplexers 63_{-1,} 63₋₂, ..., 63₋ₙ sequentially switch respective input signals supplied in parallel to input terminals 61₋₁₁, 61₋₁₂, ..., 61₋₁m; 61₋₂₁, 61₋₂₂, ..., 61₋₂ₘ; ... ; 61₋ₙ₁, 61₋ₙ₂, ... , 61-nm, and output to a rear-stage multiplexer 64₋₁ the selected signals one by one. Then, the rear-stage multiplexer 64₋₁ sequentially switches the signals supplied in parallel from the front-stage multiplexers 63₋₁, 63₋₂, ..., 63₋ₙ, and outputs from an output terminal 62 the signals one by one.

Multiplexer circuits configured, as described above, of a plurality of multiplexers connected in a tree fashion are disclosed in Patent Literatures 1 and 2 and the like.

Patent Literature 1: Japanese Patent Laid-Open No. 5-110399

Patent Literature 2: Japanese Patent Laid-Open No. 6-77792

Meanwhile, each multiplexer has a load consisting of a resistance component R and a capacitance component C. The resistance component R and the capacitance component C considerably affect the operating speed (signal-switching time) of the multiplexer. In other words, the multiplication product CR of the resistance component R and the capacitance component C, as a time constant, affects the duration from a time point when the multiplexer switches signals to be selected to a time point when the ON-state of the selected signal line is established and the signal can stably read. Accordingly, even when only the value of any one of the components becomes large, the signal-switching speed of the multiplexer is reduced. Thus, in order to accelerate the operation of the multiplexer, it is desired to reduce the values of the resistance component R and the capacitance component C.

However, in the case where a multiplexer circuit is configured of a plurality of multiplexers connected in a tree fashion, the respective resistance components R and capacitance components C of each stage that are connected through selected signal lines are connected in cascade; therefore, the respective values of the components are summed, whereby the time constant becomes large. In the example illustrated in Figure 2, e.g., in the case where the signal line through a certain input terminal is selected at the front-stage multiplexer 63₋₁ and the rear-stage multiplexer 64₋₁ selects the signal line from the multiplexer 63₋₁, the resistance component R₆₃₋₁ and the capacitance component C₆₃₋₁ of the front-stage multiplexer 63₋₁ and the resistance component R₆₄₋₁ and the capacitance component C₆₄₋₁ of the rear-stage multiplexer 64₋₁ are connected in cascade; therefore, the time-constant value becomes so large as (R₆₃₋₁ + R₆₄₋₁) x (C₆₃₋₁ + C₆₄₋₁) .

The total time constant becomes large in proportion to the depth of the tree-structure hierarchy, whereby the problem that the operating speed of the multiplexer is reduced becomes conspicuous. However, in the case where the number of signals, which are in parallel with one another and are required to be selected and outputted one by one, is extremely large, the tree-structure hierarchy of the multiplexer circuit needs to be deepened to some extent. That is because, if a great number of multiplexers are connected in parallel in the same layer, the value itself of the capacitance component C produced in each multiplexer becomes large. Accordingly, conventional multiplexer circuits configured of a plurality of multiplexers connected in a tree fashion have by no means been able to avert the problem that the operating speed is reduced.

In addition, a technique has been proposed in which, the signal-switching speed of a relay selection circuit configured of a plurality of relay switches connected in a tree fashion can be reduced, by making the ON periods of the relay switches overlap (e.g., refer to Patent Literature 3).

Patent Literature 3: Japanese Patent Laid-Open No. 2000-67722

However, the technique disclosed in Patent Literature 3 utilizes relay switches instead of multiplexers. The relay selection circuit disclosed in Patent Literature 3 can eliminate the long duration, required by a relay switch, from a time point when signals are switched to a time point when the relay switch becomes stable; therefore, it is not effective to apply the relay selection circuit directly to the multiplexer circuit 60 illustrated in Figure 2. The reason for that will be described below.

In general, when a relay switch selects and outputs a signal, a predetermined time is required. In other words, the predetermined time is required during which the relay switch is selected and then becomes completely ON. Although multiplexers also require a predetermined time, the predetermined time required to switch the multiplexers is significantly short, compared with the predetermined time required to switch relay switches. Specifically, the predetermined time required to switch signals by a multiplexer is only approximately 200 ns (nanoseconds).

Accordingly, an ultrafast clock signal having a cycle shorter than 200 ns is required, in order to make a plurality of multiplexers operate in a pipeline fashion, with their ON periods overlapped. However, it is not easy to accurately control the pipeline operation, by utilizing an ultrafast clock signal; therefore, it is difficult to realize the pipeline operation. Provided the pipeline operation is realized, a problem that the power consumption increases is posed.

Additionally, the prolonged time that, due to connecting a plurality of multiplexers in a tree fashion, is caused by the increase in the time constant has more effect than the significantly short time has that is saved by pipelining switching actions to be completed in 200 ns, i.e., in an extremely short time; therefore, even though a plurality of multiplexers connected in a tree fashion is simply made to operate in a pipeline fashion, the overall processing speed of the multiplexer circuit cannot be accelerated sufficiently.

Patent Literatures 1 and 2 described above also disclose that a plurality of multiplexers connected in a tree fashion is made to operate in a pipeline fashion, with their ON periods overlapped; however, the foregoing problems exist in this method.

### [Disclosure of the Invention]

The present invention has been implemented so as to solve the foregoing problems and the objective thereof is to make it possible to shorten the time in which a multiplexer sequentially switches a plurality of signals that are inputted thereto in parallel with one another and outputs the signals one by one, by accelerating the operating speed of the multiplexer.

In order to solve the foregoing problems, in a multiplexer circuit according to the present invention, relay switches are provided between the output terminals of multiplexers in a certain layer in a tree structure and an input terminal of a multiplexer in a layer that is one level higher than the certain layer.

According to the present invention configured as described above, the relay switch connected to the multiplexer, among a plurality of multiplexers in the certain layer, that is involved in selecting a signal is turned ON and the relay switches connected to the other multiplexers are turned OFF, whereby the resistance components and the capacitance components of the multiplexers whose corresponding relay switches have been turned OFF can be disconnected from the tree structure, thereby reducing the value of the time constant that affects the operating speed of the multiplexer circuit. As a result, the disadvantage that the increase in the time constant, due to cascade connection of the plurality of multiplexers, decelerates the operating speed of the entire multiplexer circuit can be suppressed.

Moreover, in another aspect of the present invention, a plurality of multiplexers exist in a certain layer, a plurality of relay switches are provided between the output terminals of the plurality of multiplexers and an input terminal of a multiplexer in a layer that is one level higher than the certain layer, and ON periods of at least two relay switches among the plurality of relay switches overlap each other.

According to another aspect of the present invention, configured as described above, when a certain relay switch is turned ON and a multiplexer connected thereto selects a signal, at least one more relay switch is turned ON. Therefore, when the multiplexer utilized for selecting a signal is switched to the next multiplexer, it is not required to wait a long time in which a relay switch that has been in OFF state is turned ON, because the ON state of that relay switch connected to the selected new multiplexer has already been established. In other words, it takes a relatively long time for a relay switch in OFF state to be turned ON; however, it is possible to make a plurality of multiplexers operate continuously and sequentially, without waiting such a long time.

Still moreover, in another aspect of the present invention, a plurality of multiplexers belonging to a certain layer and a plurality of relay switches connected thereto are divided into a plurality of blocks, and each block is connected to an input terminal of a multiplexer in the layer that is one level higher than the certain layer.

According to another aspect of the present invention, configured as described above, a small number of multiplexers and relay switches connected in parallel can prevent the value itself of the capacitance component of each multiplexer and the value itself of the capacitance component of each relay switch from becoming large. Accordingly, even though the multiplexers and the relay switches actually selecting signals are connected in cascade, each capacitance component is small, whereby the value of the total time constant can be reduced. As a result, the disadvantage that the increase in the time constant, due to cascade connection of the plurality of multiplexers, decelerates the operating speed of the entire multiplexer circuit can be suppressed.

Furthermore, in another aspect of the present invention, when ON periods of at least two relay switches among a plurality of relay switches are made to overlap each other, the ON periods of relay switches belonging to different blocks are made to overlap each other.

According to another aspect of the present invention configured as described above, even though a plurality of relay switches exist that are in ON state in such a way as to overlap one another, a multiplexer in a higher layer is not in a state in which a signal is selected, whereby all relay switches except for a certain relay switch are disconnected from a tree structure; therefore, the resistance components and the capacitance components of the multiplexers, in a lower layer, that are connected to the corresponding relay switches other than the certain relay switch can be disconnected from the tree structure, thereby further reducing the value of the time constant that affects the operating speed of the multiplexer circuit.

### [Brief Description of the Drawings]

Figure 1 is a diagram illustrating an example of the configuration of a conventional multiplexer circuit;
Figure 2 is a diagram illustrating another example of the configuration of a conventional multiplexer circuit;
Figure 3 is a diagram illustrating an example of the configuration of a multiplexer circuit according to the present embodiment; and
Figure 4 is a timing chart representing an example of the operation of a multiplexer circuit according to the present embodiment.

### [Best Mode for Carrying Out the Invention]

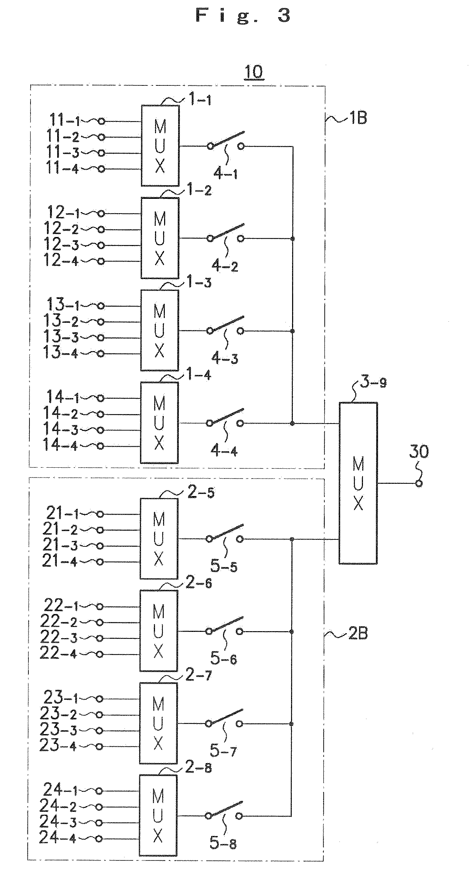

An embodiment of the present invention will be explained below, with reference to the drawings. Figure 3 is a diagram illustrating the configuration of a multiplexer circuit 10 according to the present embodiment.

As illustrated in Figure 3, the multiplexer circuit 10 according to the present embodiment configured of a plurality of multiplexers 1₋₁, 1₋₂, 1₋₃, 1₋₄, 2₋₅, 2₋₆, 2₋₇, 2₋₈, and 3₋₉ connected in a tree structure. Among the plurality of multiplexers, the first to fourth multiplexers 1₋₁ to 1₋₄ and the fifth to eighth multiplexers 2₋₅ to 2₋₈ belong to a first layer; the ninth multiplexer 3₋₉ belongs to a second layer that is one level higher than the first layer.

Among the plurality of multiplexers in the first layer, the first to fourth multiplexers 1₋₁ to 1₋₄ belong to a first block 1B, and the fifth to eighth multiplexers 2₋₅ to 2₋₈ belong to a second block 2B. The reason why the plurality of multiplexers 1₋₁ to 1₋₄ and 2₋₅ to 2₋₈ that belong to the same layer, i.e., the first layer are divided into a plurality of blocks is to enable parallel processing with ON periods of the plurality of multiplexers overlapped, as described later.

Each of the multiplexers 1₋₁ to 1₋₄, 2₋₅ to 2₋₈ and 3₋₉ sequentially switches a plurality of signals supplied in parallel and outputs the signals one by one. In other words, the first multiplexer 1₋₁ sequentially switches a plurality of signals supplied in parallel to four input terminals 11₋₁, 11₋₂, 11₋₃, and 11₋₄ and outputs the signals one by one. The second multiplexer 1₋₂ sequentially switches a plurality of signals supplied in parallel to four input terminals 12₋₁, 12₋₂, 12₋₃, and 12₋₄ and outputs the signals one by one. The third multiplexer 1_₃ sequentially switches a plurality of signals supplied in parallel to four input terminals 13₋₁, 13₋₂, 13₋₃, and 13₋₄ and outputs the signals one by one. The fourth multiplexer 1₋₄ sequentially switches a plurality of signals supplied in parallel to four input terminals 14₋₁, 14₋₂, 14₋₃, and 14₋₄ and outputs the signals one by one.

Additionally, the fifth multiplexer 2₋₅ sequentially switches a plurality of signals supplied in parallel to four input terminals 21₋₅, 21₋₂, 21₋₃, and 21₋₄ and outputs the signals one by one. The sixth multiplexer 2₋₆ sequentially switches a plurality of signals supplied in parallel to four input terminals 22₋₁, 22₋₂, 22₋₃, and 22₋₄ and outputs the signals one by one. The seventh multiplexer 2_₇ sequentially switches a plurality of signals supplied in parallel to four input terminals 23₋₁, 23₋₂, 23₋₃, and 23_₄ and outputs the signals one by one. The eighth multiplexer 2₋₈ sequentially switches a plurality of signals supplied in parallel to four input terminals 24₋₁, 24₋₂, 24₋₃, and 24₋₄ and outputs the signals one by one.

In addition, the ninth multiplexer 3₋₉ sequentially switches a plurality of signals inputted from the first and second blocks 1B and 2B and outputs from an output terminal 30 the signals one by one. In this situation, a signal inputted from the first block 1B to the ninth multiplexer 3₋₉ is outputted from one of the first to fourth multiplexers 1₋₁ to 1₋₄. Additionally, a signal inputted from the second block 2B to the ninth multiplexer 3₋₉ is outputted from one of the fifth to eighth multiplexers 2₋₅ to 2₋₈.

In the present embodiment, eight relay switches 4₋₁ to 4₋₄ and 5₋₅ to 5₋₈ are provided between the eight multiplexers 1₋₁ to 1₋₄ and 2₋₅ to 2₋₈ in the first layer and the ninth multiplexer 3₋₉ in the second layer that is one level higher than the first layer. That is because, if an extremely great number of multiplexers are connected in parallel (too many respective output terminals are integrally connected to a signal line), the value of the capacitance component C produced in each multiplexer becomes large.

That is to say, with regard to the first block 1B, the first relay switch 4₋₁ is provided between the output terminal of the first multiplexer 1₋₁ and the input terminal of the ninth multiplexer 3₋₉. The second relay switch 4₋₂ is provided between the output terminal of the second multiplexer 1₋₂ and the input terminal of the ninth multiplexer 3₋₉. The third relay switch 4₋₃ is provided between the output terminal of the third multiplexer 1₋₃ and the input terminal of the ninth multiplexer 3₋₉. Additionally, the fourth relay switch 4₋₄ is provided between the output terminal of the fourth multiplexer 1₋₄ and the input terminal of the ninth multiplexer 3₋₉. The respective output terminals of the four relay switches 4₋₁ to 4₋₄ that belong to the block 1B in the first layer are connected to a single signal line, thereby being connected to the one input terminal of the ninth multiplexer 3₋₉ in the second layer.

Additionally, with regard to the second block 2B, the fifth relay switch 5₋₅ is provided between the output terminal of the fifth multiplexer 2-₅ and the input terminal of the ninth multiplexer 3₋₉. The sixth relay switch 5-₆ is provided between the output terminal of the sixth multiplexer 2₋₆ and the input terminal of the ninth multiplexer 3₋₉. The seventh relay switch 5₋₇ is provided between the output terminal of the seventh multiplexer 2₋₇ and the input terminal of the ninth multiplexer 3₋₉. Additionally, the eighth relay switch 5₋₈ is provided between the output terminal of the eighth multiplexer 2₋₈ and the input terminal of the ninth multiplexer 3₋₉. The respective output terminals of the four relay switches 5₋₅ to 5₋₈ that belong to the block 2B in the first layer are connected to a single signal line, thereby being connected to the other input terminal of the ninth multiplexer 3_₉ in the second layer.

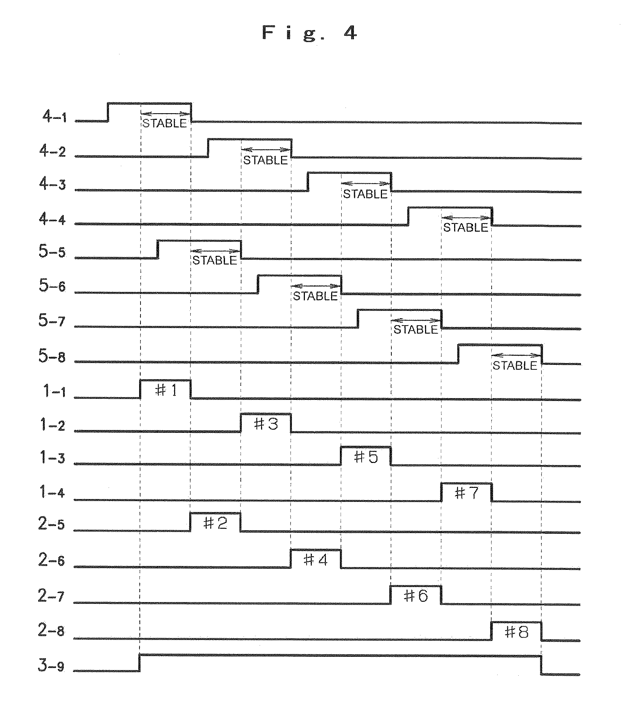

In the present embodiment, the relay switches 4_₁ to 4₋₄ and 5₋₅ to 5₋₈ are operated in such a way that the respective ON periods of at least two of the relay switches 4₋₁ to 4₋₄ and 5₋₅ to 5₋₈ overlap each other. Figure 4 is a timing chart representing an example of the operation of a multiplexer circuit 10 according to the present embodiment.

In the example in Figure 4, the relay switches 4₋₁ to 4₋₄ and 5₋₅ to 5₋₈ are operated in such a way that the respective ON periods of two of the relay switches 4₋₁ to 4₋₄ and 5₋₅ to 5₋₈ overlap each other. In other words, in the first place, the first relay switch 4₋₁ is turned ON, and the fifth relay switch 5₋₅ is then turned ON before the first relay switch 5₋₁ is turned OFF. As a result, the second half of the ON period of the first relay switch 4₋₁ and the first half of the ON period of the fifth relay switch 5₋₅ overlap each other.

Because, immediately after the first relay switch 4₋₁ is turned ON, the ON state thereof has not been established yet, the first multiplexer 1₋₁ is made active (ON-state), at the second half of the ON period of the first relay switch 4₋₁. In this situation, the ON state of the multiplexer is established in a short time, compared with the relay switch; therefore, the multiplexer can immediately become active to select a signal. The first multiplexer 1_₁ that has been activated sequentially switches a plurality of signals supplied in parallel to the four input terminals 11₋₁, 11₋₂, 11₋₃, and 11₋₄ and outputs the signals one by one. At this moment, the ON state of the first relay switch 4₋₁ has been established; therefore, the serial signals outputted from the first multiplexer 1₋₁ are sequentially inputted through the first relay switch 4₋₁ to the ninth multiplexer 3₋₉.

At this moment, the ninth multiplexer 3₋₉ has also been activated and has been switched so as to select an output signal from the first block 1B. As a result, the serial signals outputted from the first multiplexer 1₋₁ are sequentially outputted from the output terminal 30, by way of the first relay switch 4_₁ and the ninth multiplexer 3_₉.

In addition, while the first multiplexer 1_₁ is operated as described above, the other multiplexers, i.e., the second to eighth multiplexers 1₋₂ to 1₋₄ and 2₋₅ to 2₋₈ may be OFF-state or ON-state (OFF-state, in the example in Figure 4). That is because the other multiplexers, i.e., the second to eighth multiplexers 1₋₂ to 1₋₄ and 2₋₅ to 2₋₈ are all disconnected from signal selection lines, whereby, even though they are ON-state, the resistance components R and capacitance components C are not connected in cascade to enlarge the value of the time constant.

In other words, the second to fourth multiplexers 1_₂ to 1_₄ and the sixth to eighth multiplexers 2₋₆ to 2₋₈ are disconnected from the signal selection lines, because the relay switches 4₋₂ to 4₋₄ and 5₋₆ to 5₋₈ are still OFF-state. Additionally, the fifth multiplexer 2₋₅ is disconnected from the signal selection lines, because, even though the relay switch 5₋₅ is ON-state (however, the ON state has not been established yet), the ninth multiplexer 3_₉ in the second layer has not been in a state in which the ninth multiplexer 3₋₉ selects an output signal from the second block 2B. That is to say, only the first multiplexer 1₋₁ and the ninth multiplexer 3₋₉ are connected with each other by way of the first relay switch 4₋₁.

Next, the second relay switch 4₋₂ is turned ON before the fifth relay switch 5₋₅ is turned OFF. As a result, the second half of the ON period of the fifth relay switch 5_₅ and the first half of the ON period of the second relay switch 4₋₂ overlap each other. Because, immediately after the fifth relay switch 5₋₅ is turned ON, the ON state thereof has not been established yet, the fifth multiplexer 2-₅ is made active (ON-state), at the second half of the ON period of the fifth relay switch 5₋₅.

Meanwhile, as described above, part of the ON period of the first relay switch 4₋₁ and part of the ON period of the fifth relay switch 5₋₅ overlap each other. As a result, when, after the operation of the first multiplexer 1₋₁ is completed and then the fifth multiplexer 2₋₅ is activated, the ON state of the fifth relay switch 5₋₅ has already been established. Accordingly, immediately after the operation of the first multiplexer 1₋₁ is completed, the fifthmultiplexer 2₋₅ can be selected to operate, without waiting until the ON state of the fifth relay switch 5₋₅ has been established.

The fifth multiplexer 2₋₅ that has been activated sequentially switches a plurality of signals supplied in parallel to the four input terminals 21₋₁, 21₋₂, 21₋₃, and 21_₄ and outputs the signals one by one. At this moment, the ON state of the fifth relay switch 5_₅ has been established; therefore, the serial signals outputted from the fifth multiplexer 2₋₅ are sequentially inputted through the fifth relay switch 5₋₅ to the ninth multiplexer 3₋₉.

At this moment, the ninth multiplexer 3₋₉ has also been activated and has been switched so as to select an output signal from the second block 2B. In addition, as is the case with the operation in which the selection is changed from the first multiplexer 1₋₁ to the fifth multiplexer 2₋₅, the operation, in the ninth multiplexer 3₋₉, in which the selection is changed from the first block 1B to the second block 2B can rapidly be implemented. As a result, the serial signals outputted from the fifth multiplexer 2₋₅ are sequentially outputted from the output terminal 30, by way of the fifth relay switch 5₋₅ and the ninth multiplexer 3₋₉.

In addition, while the fifthmultiplexer 2₋₅ is operated as described above, the other multiplexers 1₋₁ to 1₋₄ and 2₋₆ to 2₋₈ may be OFF-state or ON-state .

Next, the sixth relay switch 5₋₆ is turned ON before the second relay switch 4₋₂ is turned OFF. As a result, the second half of the ON period of the second relay switch 4₋₂ and the first half of the ON period of the sixth relay switch 5₋₆ overlap each other. Because, immediately after the second relay switch 4₋₂ is turned ON, the ON state thereof has not been established yet, the second multiplexer 1₋₂ is made active (ON-state), at the second half of the ON period of the second relay switch 4₋₂.

Meanwhile, as described above, part of the ON period of the fifth relay switch 5₋₅ and part of the ON period of the second relay switch 4₋₂ overlap each other. As a result, when, after the operation of the fifth multiplexer 2₋₅ is completed and then the second multiplexer 1₋₂ is activated, the ON state of the second relay switch 4₋₂ has already been established. Accordingly, immediately after the operation of the fifth multiplexer 2₋₅ is completed, the second multiplexer 4₋₂ can be selected to operate, without waiting until the ON state of the second relay switch 4₋₂ has been established.

The second multiplexer 1₋₂ that has been activated sequentially switches a plurality of signals supplied in parallel to the four input terminals 12₋₁, 12₋₂, 12₋₃, and 12₋₄ and outputs the signals one by one. At this moment, the ON state of the second relay switch 4₋₂ has been established; therefore, the serial signals outputted from the second multiplexer 1₋₂ are sequentially inputted through the second relay switch 4₋₂ to the ninth multiplexer 3₋₉.

At this moment, the ninth multiplexer 3₋₉ has also been activated and has been switched so as to select an output signal from the first block 1B. In addition, as is the case with the operation in which the selection is changed from the fifth multiplexer 2₋₅ to the second multiplexer 1₋₂, the operation in which the selection is changed from the second block 2B to the first block 1B can rapidly be implemented. As a result, the serial signals outputted from the second multiplexer 1₋₂ are sequentially outputted from the output terminal 30, by way of the second relay switch 4₋₂ and the ninth multiplexer 3-₉.

In addition, while the second multiplexer 1-₂ is operated as described above, the other multiplexers 1-₁, 1₋₃, 1₋₄ and 2₋₅ to 2₋₈ may be OFF-state or ON-state .

Next, the third relay switch 4₋₃ is turned ON before the sixth relay switch 5₋₆ is turned OFF. As a result, the second half of the ON period of the sixth relay switch 5₋₆ and the first half of the ON period of the third relay switch 4₋₃ overlap each other. Because, immediately after the sixth relay switch 5₋₆ is turned ON, the ON state thereof has not been established yet, the sixth multiplexer 2₋₆ is made active (ON-state), at the second half of the ON period of the sixth relay switch 5₋₆.

Meanwhile, as described above, part of the ON period of the second relay switch 4₋₂ and part of the ON period of the sixth relay switch 5₋₆ overlap each other. As a result, when, after the operation of the second multiplexer 1₋₂ is completed and then the sixth multiplexer 2₋₆ is activated, the ON state of the sixth relay switch 5₋₆ has alreadybeenestablished. Accordingly, immediately after the operation of the second multiplexer 1₋₂ is completed, the sixth multiplexer 2₋₆ can be selected to operate, without waiting until the ON state of the sixth relay switch 5₋₆ has been established.

The sixth multiplexer 2₋₆ that has been activated sequentially switches a plurality of signals supplied in parallel to the four input terminals 22₋₁, 22₋₂, 22₋₃, and 22₋₄ and outputs the signals one by one. At this moment, the ON state of the sixth relay switch 5₋₆ has been established; therefore, the serial signals outputted from the sixth multiplexer 2₋₆ are sequentially inputted through the sixth relay switch 5₋₆ to the ninth multiplexer 3₋₉.

At this moment, the ninth multiplexer 3_₉ has also been activated and has been switched so as to select an output signal from the second block 2B. In addition, as is the case with the operation in which the selection is changed from the second multiplexer 1_₂ to the sixth multiplexer 2₋₆, the operation in which the selection is changed from the first block 1B to the second block 2B can rapidly be implemented. As a result, the serial signals outputted from the sixth multiplexer 2₋₆ are sequentially outputted from the output terminal 30, by way of the sixth relay switch 5₋₆ and the ninth multiplexer 3₋₉.

In addition, while the sixthmultiplexer 2₋₆ is operated as described above, the other multiplexers 1₋₁ to 1₋₄ and 2₋₅, 2₋₇, and 2₋₈ may be OFF-state or ON-state .

Similarly hereinafter, by keeping the ON periods of the relay switches overlapped, e.g., the seventh relay switch 5₋₇, the fourth relay switch 4₋₆, and the eighth relay switch 5₋₈ in that order, the relay switches are sequentially turned ON and the multiplexers are sequentially turned ON, e.g., the third multiplexer 1₋₃, the seventh multiplexer 2₋₇, the fourth multiplexer 1₋₄, and the eighth multiplexer 2₋₈ in that order.

While, as described above, the first to fourth multiplexers 1₋₁ to 1₋₄ in the first block 1B and the fifth to eighth multiplexers 2₋₅ to 2₋₈ in the second block 2B operate alternately and continuously, the ninth multiplexer 3₋₉ is always ON-state and alternately selects the first block 1B and the second block 2B. The ninth multiplexer 3₋₉ in ON state sequentially switches a plurality of signals supplied from the first to eighth multiplexers 1₋₁ to 1₋₄ and 2₋₅ to 2₋₈ and outputs the signals one by one from the output terminal 30.

As explained heretofore, according to the present embodiment, the relay switches 4₋₁ to 4₋₄ and 5₋₅ to 5₋₈ are provided between the respective output terminals of the multiplexers 1₋₁ to 1₋₄ and 2₋₅ to 2₋₈ in the first layer and the corresponding input terminals of the ninth multiplexer 3₋₉ in the second layer, in a tree structure; therefore, by turning OFF the relay switches connected to the multiplexers, in the first layer, that are not in the signal-selection period, the resistance components R and the capacitance components C of the multiplexers, in the first layer, whose corresponding relay switches are turned OFF can be disconnected from the tree structure. As a result, the value of the time constant CR, which affects the operating speed of the multiplexer circuit 10, can be suppressed from increasing. In addition, in general, the resistance of a relay switch is sufficiently small, compared with that of a multiplexer; therefore, even though a relay switch is connected with a multiplexer in cascade, the value of the serial resistance can be reduced compared with the case where multiplexers are connected in cascade with each other, whereby the value of the time constant CR can be reduced.

Moreover, in the present embodiment, the multiplexers 1₋₁ to 1₋₄ and 2₋₅ to 2₋₈ and the relay switches 4₋₁ to 4₋₄ and 5₋₅ to 5₋₈ are divided into one group, i.e., the first block 1B and the other group, i.e., the second block 2B; therefore, the decrease in the number of multiplexers and relay switches connected in parallel can prevent the value itself of the capacitance component C of each multiplexer and the value itself of the capacitance component C of each relay switch from becoming large.

As described above, according to the present embodiment, it is possible that, by preventing a great number of multiplexers and relay switches from being connected at the same time, a great number of resistance components R and a plurality of capacitance components C are prevented from being connected in cascade and the values themselves of the respective resistance components R and the capacitance components C of each multiplexer and each relay switch are reduced. Accordingly, the value of the total time constant CR can be reduced, whereby the disadvantage can be prevented that the increase in the time constant CR reduces the operating speed of the entire multiplexer circuit 10.

Moreover, according to the present embodiment, the eight relay switches 4₋₁ to 4₋₄ and 5₋₅ to 5₋₈ are operated in such a way that the respective ON periods of two of that relay switches overlap each other; therefore, when the multiplexer, in the first layer, utilized for selecting a signal is switched to the next multiplexer, it is not required to wait a long time in which the relay switch, connected to the selected new multiplexer, that is in OFF state is turned ON. In other words, it is possible that, without waiting a long time until the ON state of the relay switch has been established, the multiplexers 1₋₁ to 1-₄ and 2-₅ to 2-₈ in the first layer are continuously switched to operate sequentially.

As described heretofore, even though the multiplexers 1₋₁ to 1_₄, 2₋₅ to 2₋₈, and 3₋₉ are connected in a tree structure, the time constant CR does not increase, whereby signals can sequentially be selected at the high switching speed of the multiplexers 1₋₁ to 1₋₄, 2₋₅ to 2₋₈, and 3₋₉. In other words, a plurality of input signals can be switched at an extremely short cycle of 200 ns and sequentially outputted one by one; therefore, the speedup of the multiplexer circuit 10 can be realized.

In addition, in the foregoing embodiment, an example has been explained in which the first to fourth multiplexers 1₋₁ to 1₋₄ in the first block 1B and the fifth to eighth multiplexers 2₋₅ to 2₋₈ in the second block 2B are alternately selected; however, the present invention is not limited to the example. For instance, the selection may be implemented in such a way that, in the first place, the first to fourth multiplexers 1₋₁ to 1_₄ in the first block 1B are sequentially selected and then the fifth to eighth multiplexers 2₋₅ to 2₋₈ in the second block 2B are sequentially selected.

However, it is more desirable to alternately select the first and second blocks 1B and 2B; that is because, even though the ON states of two relay switches overlap each other, the ninth multiplexer 3₋₉ is not selected, any one of the two relay switches is disconnected from the tree structure.

For example, when the first relay switch 4₋₁ and the second relay switch 4₋₂ are made ON-state at the same time in such a way as to overlap each other, the two relay switches 4₋₁ and 4₋₂ are both connected with the third multiplexer 3₋₉. In this case, if the two multiplexers 1-₁ and 1-₂, which are connected to the two relay switches 4₋₁ and 4₋₂, respectively, are both ON-state, the two multiplexers 1₋₁ and 1₋₂ are also connected with the tree structure. Accordingly, the time constant CR increases by the value corresponding to the time constants produced by the two multiplexers 1₋₁ and 1₋₂.

In contrast, even though, as the foregoing embodiment, the first relay switch 4-₁ and the fifth relay switch 5-₅ are made ON-state at the same time in such a way as to overlap each other, the fifth multiplexer 2-₅ is disconnected from the tree structure, because the ninth multiplexer 3₋₉ has not been in a state in which the ninth multiplexer 3₋₉ selects an output signal from the second block 2B. Therefore, in order to further reduce the time constant CR, it is preferable to implement connection, by alternately switching the first block 1B and the second block 2B.

Moreover, in the foregoing embodiment, an example has been explained in which the multiplexers 1₋₁ to 1₋₄ and 2₋₅ to 2₋₈ in the first layer are each provided with four input terminals; however, the number of the input terminals is just an example, and the present invention is not limited thereto. Still moreover, in the foregoing embodiment, an example has been explained in which the multiplexer 3₋₉ in the second layer is provided with two input terminals (an example in which the number of blocks is two); however, the number of the input terminals (the number of blocks) is just an example, and the present invention is not limited thereto.

Furthermore, in the foregoing embodiment, an example has been explained in which the eight multiplexers 1₋₁ to 1₋₄ and 2₋₅ to 2₋₈ are provided in the first layer; however, the number of multiplexers is just an example, and the present invention is not limited thereto.

Furthermore, in the foregoing embodiment, the configuration of a tree connection in a two-layer structure consisting of the first and second layers has been explained; however, the number of layers is just an example, and the present invention is not limited thereto.

Additionally, the foregoing embodiment is nothing but what describes only an example of reductions to practice in which the present invention is implemented; thus, the technical scope of the present invention should not be construedinalimitedfashion. Inotherwords, the present invention can be implemented in various forms, without departing from the spirit or the principal feature thereof.

### [Industrial Applicability]

The present invention is useful for a multiplexer circuit that sequentially switches a plurality of signals that are inputted thereto in parallel with one another and outputs the signals one by one. As a technique to which a multiplexer circuit according to the present invention is applied, e.g., a test system is conceivable with which inspection on the electrical properties of an ultra multi-pin output LSI is implemented. In this case, the present invention is suitable for making a multiplexer circuit switch one by one a great number of analogue signals outputted from the LSI and output the signals to an A/D converter, and for sequentially outputting the digitized data to an inspection/evaluation section.

## Claims

1. A multiplexer circuit comprising:
a plurality of multiplexers each of which sequentially switches a plurality of signals that are inputted thereto in parallel with one another and outputting the signals one by one, the multiplexers being connected in a tree structure; and
a relay switch provided between the output terminal of the multiplexer in a certain layer in the tree structure and an input terminal of the multiplexer in a layer that is one level higher than the certain layer.

2. The multiplexer circuit according to claim 1, wherein a plurality of multiplexers exist in the certain layer, a plurality of relay switches are provided between the output terminals of the plurality multiplexers in the certain layer and an input terminal of the multiplexer in the layer that is one level higher than the certain layer, and ON periods of at least two relay switches among the plurality of relay switches overlap each other.

3. The multiplexer circuit according to claim 1, wherein a plurality of multiplexers exist in the certain layer, a plurality of relay switches are provided between the output terminals of the plurality of multiplexers in the certain layer and an input terminal of the multiplexer in the layer that is one level higher than the certain layer, the plurality of multiplexers and the plurality of relay switches are divided into a plurality of blocks, and each block is connected to the input terminal of the multiplexer in the layer that is one level higher than the certain layer.

4. The multiplexer circuit according to claim 3, wherein ON periods of at least two relay switches among the plurality of relay switches overlap each other.

5. The multiplexer circuit according to claim 4, wherein the at least two relay switches among the plurality of relay switches belong to the respective blocks that are different from one another.
